Europäisches Patentamt

European Patent Office

Office européen des brevets

(19)

(11) **EP 0 890 957 A1**

(12) **DEMANDE DE BREVET EUROPEEN**

(43) Date de publication:
**13.01.1999 Bulletin 1999/02**

(51) Int. Cl.$^6$: **G11C 27/02**

(21) Numéro de dépôt: 98202292.3

(22) Date de dépôt: **08.07.1998**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **11.07.1997 FR 9708893**

(71) Demandeur:
**Koninklijke Philips Electronics N.V.**
**5621 BA  Eindhoven (NL)**

(72) Inventeur: **Chevallier, Gilles**
**75008 Paris (FR)**

(74) Mandataire: **Caron, Jean**
**Société Civile S.P.I.D.**
**156, Boulevard Haussmann**
**75008 Paris (FR)**

(54) **Echantillonneur-bloqueur**

(57)  Un comparateur (22) compare le signal de sortie (Vout), délivré par un amplificateur de sortie (21), avec un signal d'entrée (Vin). Il commande, selon le sens de la comparaison, la mise en conduction de l'une ou de l'autre de deux sources (IGA, IGB) qui débitent des courants opposés. Deux montages (A, B) complémentaires comportent chacun un premier transistor (T1A, T1B) et un second transistor (T2A, T2B). Chaque premier transistor (T1A, T1B) a sa base commandée par une des sources de courant pour charger une première capacité (C1) reliée à la sortie, et commande en outre la conduction du second transistor correspondant.

Les bases des seconds transistors (T2A, T2B) sont connectés ensemble à la première capacité (C1) et leurs émetteurs sont connectés ensemble à l'entrée "-" de l'amplificateur de sortie (21), laquelle est reliée à une tension de référence (Vref) via une résistance (20) et à la sortie (Vout) via une seconde capacité (C2).

Applications : en association avec d'autres circuits, par exemple avec un convertisseur analogique/numérique.

FIG. 1

**Description**

La présente invention concerne un circuit intégré contenant un échantillonneur-bloqueur destiné à recevoir un signal d'entrée et à délivrer un signal de sortie, l'échantillonneur-bloqueur comportant une première et une seconde capacité, une première armature de chaque capacité étant connectée à la sortie d'un amplificateur de sortie qui constitue la sortie de l'échantillonneur-bloqueur, une liaison étant prévue entre la seconde armature de la première capacité et l'entrée "-" de l'amplificateur de sortie, la seconde armature de la seconde capacité étant connectée à cette entrée.

Un tel échantillonneur-bloqueur s'utilise en association avec d'autres circuits, par exemple avec un convertisseur analogique/numérique dont il peut améliorer la vitesse.

Un échantillonneur-bloqueur selon le préambule ci-dessus est connu du document US 5,015,877. L'échantillonneur-bloqueur décrit dans ce document comprend en outre un amplificateur d'entrée à transconductance, un amplificateur du signal "S/H" qui commande un interrupteur, ainsi qu'un amplificateur pour charger la seconde capacité à partir du courant de l'amplificateur d'entrée, les secondes armatures des deux capacités étant reliées l'une à l'autre par une résistance.

Un objet de l'invention est de procurer un échantillonneur-bloqueur plus simple, et offrant une bonne souplesse de réglage.

A cet effet, l'échantillonneur-bloqueur comprend un agencement comparateur pour comparer le signal de sortie avec le signal d'entrée, agencement qui délivre, lors de phases de comparaison, un courant de valeur prédéterminée, dans un sens ou dans l'autre selon le sens de la comparaison, et un dispositif pour, lorsqu'un courant est fourni par cet agencement, charger rapidement la première capacité à partir d'une borne d'alimentation et faire passer pratiquement tout le courant de l'agencement dans la seconde capacité et pour, lorsqu'aucun courant n'est fourni par l'agencement, connecter ensemble les deux capacités à l'entrée de l'amplificateur de sortie.

L'invention est donc basée entre autres sur l'idée de commander le courant de charge des capacités au moyen d'un comparateur entre la tension de sortie et celle d'entrée, ce qui permet de simplifier le circuit de charge et de décharge des capacités.

Dans un mode de réalisation particulier, l'agencement comparateur est constitué par un comparateur proprement dit, possédant deux sorties complémentaires qui commandent la mise en conduction, selon le sens de la comparaison entre les signaux appliqués à son entrée, de l'une ou de l'autre de deux sources de courant qui débitent en sens inverse.

Avantageusement, pour charger rapidement la première capacité, le dispositif comprend deux montages complémentaires correspondant chacun à l'un des sens du courant de l'agencement comparateur, et chaque montage comporte un premier transistor dont la base est alimentée par ce courant et dont le collecteur est relié à une borne d'alimentation, les émetteurs des premiers transistors des deux montages étant reliés ensemble à la seconde armature de la première capacité.

Ainsi, la première capacité peut être chargée très rapidement.

Avantageusement, chaque montage comporte un second transistor dont la base est reliée à l'émetteur du premier transistor et dont le collecteur est relié à la base du premier transistor, les émetteurs des seconds transistors des deux montages étant reliés ensemble à l'entrée de l'amplificateur de sortie, laquelle est reliée à une tension de référence via une résistance ainsi qu'à la seconde armature de la seconde capacité.

Ainsi, la liaison entre la première et la seconde capacité est commandée et donc plus efficace.

Dans une application particulièrement avantageuse, l'échantillonneur-bloqueur sert à la mise en forme du signal d'entrée d'un convertisseur analogique-numérique.

Ces aspects de l'invention ainsi que d'autres aspects plus détaillés apparaîtront plus clairement grâce à la description suivante d'un mode de réalisation constituant un exemple non limitatif.

La Figure 1 est un schéma d'un échantillonneur-bloqueur selon l'invention.
La Figure 2 est un diagramme tension/temps illustrant son fonctionnement.
La Figure 3 illustre une application de l'échantillonneur-bloqueur.

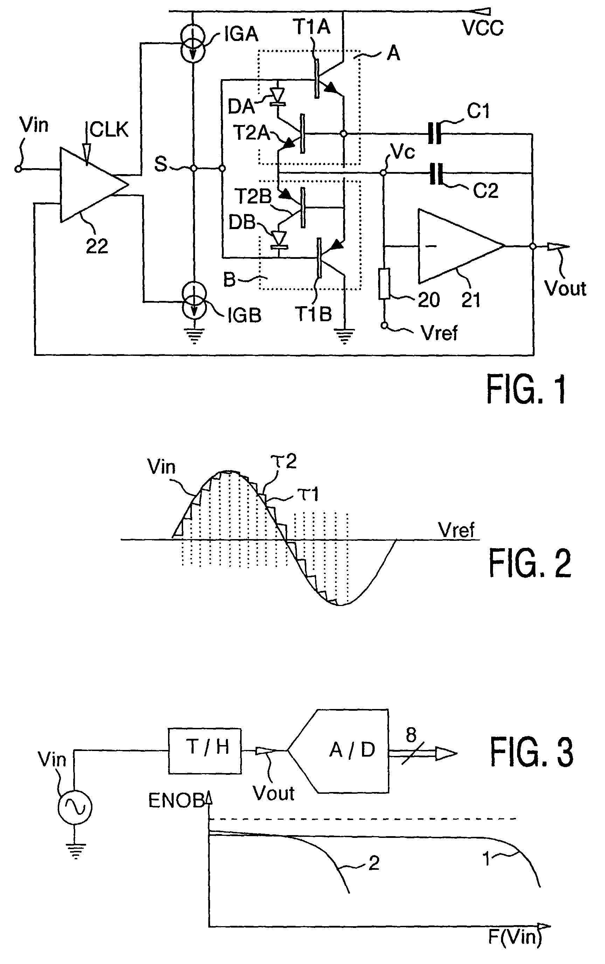

L'échantillonneur-bloqueur de la Figure 1 comprend une borne d'entrée Vin et une borne de sortie Vout. Un comparateur 22 compare le signal de sortie Vout avec le signal d'entrée Vin. Il possède deux sorties complémentaires, c'est-à-dire fournissant deux signaux complémentaires qui commandent, à des instants réglés par une horloge CLK, la mise en conduction de l'une ou de l'autre de deux sources de courant IGA et IGB, selon le sens de la comparaison entre les signaux Vin et Vout. La source IGA introduit un courant de valeur IGA dans un noeud S, et la source IGB extrait un courant de valeur IGB de ce noeud S. L'ensemble du comparateur et des sources IGA, IGB constitue le susdit agencement comparateur.

A partir du noeud S, un dispositif commande la tension d'un noeud Vc relié à l'entrée "-" d'un amplificateur de sortie 21 dont la sortie constitue la sortie Vout de l'échantillonneur-bloqueur. Cet amplificateur 21 présente un gain négatif fini, de valeur absolue β.

Ce dispositif comprend deux montages complémentaires. Un montage A comporte un premier transistor T1A et un second transistor T2A, de type NPN, et l'autre montage B comporte un premier transistor T1B et un second transistor T2B, de type PNP. Dans chacun de ces montages, la base du premier transistor T1A ou T1B est reliée au noeud S, son collecteur est relié à une source de tension fixe, respectivement l'alimentation VCC et la masse, et son émetteur est relié à la base du second transistor T2A ou T2B, dont le collecteur est relié à la base du premier transistor via une diode DA ou DB, montée dans le sens passant du courant principal du second transistor.

Une première armature d'une capacité C1 de valeur C1, ainsi qu'une première armature d'une capacité C2 de valeur C2, sont reliées à la sortie Vout.

Les bases des deux seconds transistors T2A et T2B sont reliées ensemble à la seconde armature de la capacité C1.

Les émetteurs des deux seconds transistors sont reliés ensemble :

- à l'entrée "-" de l'amplificateur de sortie 21,
- à une tension de référence Vref via une résistance 20 de valeur R20,
- à la seconde armature de la capacité C2.

La tension Vref a une valeur située environ à la moitié de celle de la tension d'alimentation VCC.

Le fonctionnement du montage A va être décrit. Le fonctionnement du montage B s'en déduit mutatis mutandis : les deux montages complémentaires jouent un rôle homologue, selon que c'est la source IGA ou la source IGB qui débite.

Lorsque la source IGA débite, le transistor T1A est rendu conducteur et son courant principal venant de VCC charge rapidement la capacité C1. En même temps, ce courant alimente la base du transistor T2A ; le courant de la source IGA passe donc à peu près entièrement dans le trajet principal du transistor T2A et charge la capacité C2. Lorsque la source IGA est coupée, les capacités C1 et C2 sont reliées l'une à l'autre par la diode base-émetteur du transistor T2A pour se décharger ensemble via la résistance 20.

Le dispositif tire parti d'un effet analogue à celui connu appelé "effet Miller", concernant ici l'amplificateur 21 : le courant de la source IGA, ayant traversé T2A, se répartit entre la résistance 20 et la capacité C2, en supposant négligeable le courant d'entrée de l'amplificateur 21. Lorsque la tension monte sur le noeud Vc, elle baisse sur la sortie Vout, et la tension Vout transmise par les capacités C1 et C2 empêchent la tension sur Vc de monter aussi vite qu'elle le ferait si l'armature de droite de C1 et C2 était reliée à une tension fixe. Tout se passe comme si la valeur des capacités C1 et C2 était plus grande qu'elle n'est. Il est donc possible d'utiliser des capacités de faible valeur, qui ainsi sont intégrables. Lorsqu'un courant IGA passe dans T2A, la tension évolue à l'entrée de l'amplificateur 21 avec une rapidité qui dépend de la valeur de IGA, de C2, et du gain $\beta$ de l'amplificateur 21. Lorsque IGA disparaît, les courants de T1A et de T2A disparaissent, et la tension évolue en Vc avec une constante de temps

$$\tau2 = R20 \times \beta \times (C1 + C2) .$$

Pendant une impulsion d'horloge qui déclenche l'arrivée d'un nouvel échantillon, la tension Vout passe rapidement de la valeur ancienne à la nouvelle valeur puis, entre deux temps d'horloge, évolue vers la tension Vref avec la constante de temps $\tau2$ relativement longue. La Figure 2 illustre ce fonctionnement ; des variations de tension dans chacune des deux situations sont indiquées respectivement par "$\tau1$" et "$\tau2$" ; les lignes verticales en trait pointillé indiquent l'horloge.

Selon l'exemple d'application de la Figure 3, un échantillonneur T/H, appelé communément "Track and Hold", est placé en amont d'un convertisseur analogique/numérique A/D, qui délivre un signal numérique à huit bits, représentant par exemple un signal vidéo. La courbe placée en dessous du schéma illustre l'avantage de cette application. En ordonnée est indiquée la précision effective du signal de sortie, exprimée en nombre de bits effectifs ENOB, en abscisse est indiquée la fréquence F(Vin) du signal d'entrée. Les courbes 1 et 2 représentent respectivement le résultat avec et sans l'échantillonneur T/H. Avec l'échantillonneur, le nombre de bits effectif atteint pratiquement la limite théorique régie par la règle de Nyquist.

**Revendications**

1. Circuit intégré contenant un échantillonneur-bloqueur destiné à recevoir un signal d'entrée et à délivrer un signal de sortie, l'échantillonneur-bloqueur comportant une première et une seconde capacité, une première armature de chaque capacité étant connectée à la sortie d'un amplificateur de sortie qui constitue la sortie de l'échantillonneur-bloqueur, une liaison étant prévue entre la seconde armature de la première capacité et l'entrée "-" de l'amplificateur de sortie, la seconde armature de la seconde capacité étant connectée à cette entrée, **caractérisé en ce que** l'échantillonneur-bloqueur comprend un agencement comparateur pour comparer le signal de sortie avec le signal d'entrée, agencement qui délivre, lors de phases de comparaison, un courant de valeur prédéterminée, dans un sens ou dans l'autre selon le sens de la comparaison, et un dispositif pour, lorsqu'un courant est fourni par l'agencement, charger rapidement la première capacité à partir d'une borne d'alimentation et faire passer pratiquement tout le courant de l'agencement dans la seconde capacité et pour, lorsqu'aucun courant n'est fourni par l'agencement, connecter ensemble les deux capacités à l'entrée de l'amplificateur de sortie.

2. Circuit intégré selon la revendication 1, **caractérisé en ce que** l'agencement comparateur est constitué par un comparateur proprement dit, possédant deux sorties complémentaires qui commandent la mise en conduction, selon le sens de la comparaison entre les signaux appliqués à son entrée, de l'une ou de l'autre de deux sources de courant qui débitent en sens inverse.

3. Circuit intégré selon la revendication 1, **caractérisé en ce que,** pour charger rapidement la première capacité, le dispositif comprend deux montages complémentaires correspondant chacun à l'un des sens du courant de l'agencement comparateur, et chaque montage comporte un premier transistor dont la base est alimentée par ce courant et dont le collecteur est relié à une borne d'alimentation, les émetteurs des premiers transistors des deux montages étant reliés ensemble à la seconde armature de la première capacité.

4. Circuit intégré selon la revendication 3, **caractérisé en ce que** chaque montage comporte un second transistor dont la base est reliée à l'émetteur du premier transistor et dont le collecteur est relié à la base du premier transistor, les émetteurs des seconds transistors des deux montages étant reliés ensemble à l'entrée de l'amplificateur de sortie, laquelle est reliée à une tension de référence via une résistance ainsi qu'à la seconde armature de la seconde capacité.

5. Circuit intégré selon la revendication 1, **caractérisé en ce que** l'échantillonneur-bloqueur est associé à un convertisseur analogique-numérique.

**FIG. 1**

**FIG. 2**

**FIG. 3**

Office européen
des brevets

**RAPPORT DE RECHERCHE EUROPEENNE**

Numéro de la demande

EP 98 20 2292

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | WO 90 03034 A (ANALOG DEVICES INC) 22 mars 1990 * abrégé; figures 5-9 * * page 5 - page 7 * --- | 1,2 | G11C27/02 |
| D,A | US 5 015 877 A (KING KEN R) 14 mai 1991 * colonne 1, ligne 6 - colonne 4, ligne 50; figure 2 * --- | 1,2,5 | |
| A | US 4 801 823 A (YOKOYAMA KENJI) 31 janvier 1989 * colonne 2, ligne 33 - colonne 3, ligne 59; figures 7,9 * --- | 1,3,4 | |
| A | DE 34 01 516 A (ANT NACHRICHTENTECH) 25 juillet 1985 ----- | | |

**DOMAINES TECHNIQUES RECHERCHES (Int.Cl.6)**

G11C

Le présent rapport a été établi pour toutes les revendications

| Lieu de la recherche | Date d'achèvement de la recherche | Examinateur |
|---|---|---|
| LA HAYE | 30 octobre 1998 | Czarik, D |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)